# EUROPEAN PATENT SPECIFICATION

(11) **EP 4 050 663 B1**
(45) Date of publication and mention of the grant of the patent: **06.12.2023**
(21) Application number: 22169412.8
(22) Date of filing: 06.07.2018
(51) Int. Cl.: H01L 31/042, H01L 31/048, H02S 20/10

(54) **ASSEMBLY AND MOUNTING OF SOLAR CELLS**
ZUSAMMENBAU UND MONTAGE VON SOLARZELLEN
ENSEMBLE ET MONTAGE DE CELLULES SOLAIRES

(43) Date of publication of application: 31.08.2022
(62) Divisional of application: 18182315.4
(73) Proprietor: SolAero Technologies Corp., a corporation of the state of Delaware, Albuquerque, NM 87123 (US)
(72) Inventor: WROSCH, Matthew, Escondido, CA 92027 (US); MCNAUL, Eric, BOULDER, CO 80301 (US); STERN, Theodore, EL CAJON, CA 92020 (US); HERNANDEZ, Fadel, LA MESA, CA 91942 (US)
(74) Representative: de Rooij, Mathieu Julien

(56) References cited:
- WO-A2-2009/108874
- WO-A2-2010/053301
- CN-A- 101 192 630
- JP-A- 2002 083 992
- US-A1- 2003 005 954
- US-A1- 2016 194 072

## Description

### Field of the Disclosure

The present disclosure relates to the field of airfoils, and photovoltaic solar arrays mounted on such airfoils, and more particularly to fabrication processes utilizing, for example, multijunction solar cells based on III-V semiconductor compounds mounted on a flexible film and adhered to the airfoil structure.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

Solar panels are generally formed by combining a large number of solar cells in an array. Individual solar cells, frequently with a rectangular or generally square-shape and sometimes with cropped corners, are connected in series to form a string of solar cells, whereby the number of solar cells used in the string determines the output voltage. Solar cells or strings of solar cells can also be interconnected in parallel, so as to increase the output current. In the field of aerospace applications, individual solar cells are provided with interconnects which are then combined to form an array. Conventionally, these large solar cells have been mounted on a support and interconnected using electrical interconnects.

There is a continuing need for improved methods of manufacturing and assembling photovoltaic solar arrays that can result in decreases in cost and/or increases in performance.

Accordingly, the present disclosure provides improved methods of manufacturing and assembling photovoltaic solar arrays on a surface that requires a highly smooth surface to achieve laminar flow such as an airfoil for an aircraft wing or other surface that can result in decreases in cost, greater compactness, and increases performance.

US2003005954 A1, JP2002083992 A, CN101192630 A, and US2016194072 A1 disclose methods of assembling solar cell arrays on an assembly fixture having a concave surface.

### SUMMARY OF THE INVENTION

### Objects of the Disclosure

It is an object of the present disclosure to provide processes for producing solar cell panels for aerospace applications.

It is another object of the present disclosure to provide an assembly tool for producing solar cell panels for aerospace applications.

It is another object of the disclosure to provide methods for making a solar cell panel with an extremely smooth outer surface.

It is another object of the disclosure to provide for an assembly fixture and method that facilitates assembly of at least certain steps of the process for manufacture of solar cell assemblies on the fixture.

Some implementations of the present disclosure may incorporate or implement fewer of the aspects and features noted in the foregoing objects.

### Features of the Disclosure

All ranges of numerical parameters set forth in this disclosure are to be understood to encompass any and all subranges or "intermediate generalizations" subsumed therein. For example, a stated range of "1.0 to 2.0 microns" for a value of a dimension of a component such as its thickness should be considered to include any and all subranges beginning with a minimum value of 1.0 microns or more and ending with a maximum value of 2.0 microns or less, e.g., 1.0 to 1.2, or 1.3 to 1.4, or 1.5 to 1.9 microns.

Briefly, and in general terms, the present disclosure provides a method of fabricating a solar cell panel in a process as defined by the subject-matter of claim 1, by applying an adhesive film to a fixture of support, positioning a solar cell assembly over the adhesive film, applying pressure to adhere the assembly to the support; and removing the assembly from the fixture.

In one embodiment, the present disclosure provides a method of fabricating an airfoil comprising: providing an assembly fixture having a smooth, concave surface; mounting a film composed of ethylene tetrafluoroethylene (ETFE) directly on the surface of the fixture; mounting a film composed of a non-crosslinked silicone pressure sensitive adhesive (PSA) directly over the ETFE film; mounting an array of interconnected solar cells, each having a top (or light-facing) side, and a back side, directly over the adhesive film; mounting an uncured supporting film composed of a composite material directly on the back side of the solar cell array adjacent the adhesive film; co-curing the film of composite material so that the array of interconnected solar cells is bonded to the supporting film; and removing the bonded and cured film of the composite material and an array of interconnected solar cells with the ETFE film from the assembly fixture.

In another example useful for understanding the invention but not covered by the scope of the claims, the present disclosure provides a method of fabricating a solar cell array carrier comprising: providing a carbon composite face sheet; providing a double sided adhesive film and positioning it on the top surface of the face sheet; bonding the bottom surface of the adhesive film to the top surface of the face sheet by co-curing; sequentially positioning a sequence of solar cell assemblies over the top surface of the adhesive film; and sequentially bonding each of the sequence of solar cell assemblies to a predefined region on the top surface of the face sheet.

In some embodiments, a plurality of solar cells are disposed closely adjacent to one another on each of the strips by a distance between 5 and 25 microns.

In some embodiments, each of the solar cells has a dimension in the range of 0.5 to 10 mm on a side.

In some embodiments of the disclosure, the back side support is a polymide film layer such as KAPTON. KAPTON^{®} is a trademark of E.I. du Pont de Nemours and Company. The chemical name for KAPTON^{®} is poly (4, 4'-oxydiphenylene-pyromellitimide). Other polymide film sheets or layers may also be used.

In some embodiments, the support has a thickness of between 25 and 100 microns, or between 1 mil (25.4 µm) and 4 mil (101.6 µm).

In some embodiments, there further comprises a foam supporting structure bonded to the support or film of the composite material.

In some embodiments, the array of interconnected solar cells are III-V compound semiconductor multijunction solar cells.

In some embodiments, the concave surface of the assembly fixture has a surface roughness of less than 0.001 inches (25.40 microns) rms.

In some embodiments, the concave surface of the assembly fixture is shaped such as to form an airfoil shaped surface.

A pressure-sensitive adhesive (PSA) is an adhesive which forms a bond between the adhesive and the adherend when pressure is applied. In some embodiments, the pressure sensitive adhesive is a single monomer or co-monomer silicone blend.

In some embodiments, a double-faced pressure-sensitive adhesive template or patch is positioned on the backside of the solar cell assembly. In some embodiments, the PSA may be a patterned layer, or it may be a continuous layer. For instance, the PSA may be patterned into the shape of solar cells.

In some embodiments the support is a foam interior airfoil with a composite covering.

In some embodiments, the double-faced pressure-sensitive adhesive template or patch and the polyimide film are bonded together without the use of a co-curing process.

In some embodiments, the double-faced pressure-sensitive adhesive template is covered at least partially with a release liner which is removed before making the bonding with the substrate.

In some embodiments, the PSA film may be an acrylic or a silicone adhesive, or any other suitable material.

In some embodiments, the PSA film may have one or two release liners, or possibly no release liners. In some embodiments, the PSA film may have continuous release liners that are removed in one step, or it may have a multiplicity of release liners that are removed individually.

In some embodiments, the substrate may be a rigid substrate, such as an aluminum honeycomb substrate with carbon composite face sheet, or it may be a flexible substrate, such as a polymide film.

In some embodiments, the PSA film may also be applied to the back of the solar cells or solar cell assemblies.

In some embodiments, a pressure sensitive adhesive (PSA) film is prepared as a single layer.

In some embodiments, the PSA film may be prepared onto a permanent flexible substrate, such as a polyimide, with a release liner or liners on the opposite side.

In some embodiments, there may be a multiplicity of individual PSA patterns, each with its own front and back release liners. In some embodiments, there may be a multiplicity of individual PSA patterns, with one single, continuous release liner on one side and a multiplicity of release liners on the opposite side.

In some embodiments, there may be a multiplicity of individual PSA patterns with two continuous release layers covering the multiplicity of patterns on both sides. In some embodiments, there may be a single, continuous film of PSA with release liners on one or both sides.

In some embodiments, the PSA film is used to bond solar cells or solar cell assemblies to a substrate.

In some embodiments, the PSA film may be applied first to the substrate, and then the solar cells attached to the PSA film, or it may be applied first to the back of the solar cells, and then the solar cells with PSA film are applied to the substrate.

In some embodiments, if the PSA film is prepared on a permanent substrate, the solar cells or solar cell assemblies may be applied directly to the PSA film.

In some embodiments, the assembly of polyimide-PSA-release liner is bonded directly to a solar panel substrate by co-curing the polyimide film to the face of the solar panel substrate. The solar panel substrate to which the polyimide is bonded may be composite substrate, and it may have a carbon composite face sheet. It may be a rigid substrate, or it may be a flexible substrate.

In some embodiments, following the above described assembly, the substrate is ready to have the solar cells or solar cell assemblies bonded to it. The release liner is removed when it is time to bond the solar cells, which exposes the PSA, and the solar cells are bonded to the PSA and the substrate. Since the PSA thickness is precisely controlled during manufacturing, the bondline is uniform and there is less opportunity to entrap air than when a liquid adhesive is used.

In another aspect, the present disclosure provides an aircraft or airfoil body and its method of fabrication comprising a solar array manufactured according to any of the examples disclosed herein.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### BRIEF DESCRIPTION OF THE DRAWING

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The drawings comprise the following figures:
FIG. 1 is a perspective view of a fixture for assembling the airfoil or solar cell assembly according to an example of the present disclosure;
FIG. 2 is a cross-sectional view of the surface of the fixture of FIG. 1;
FIG. 3 is a cross-sectional view of the assembly of FIG. 2 after the next process step according to this example;
FIG. 4 is a cross-sectional view of the assembly of FIG. 2 after the next process step according to this example;
FIG. 5 is a cross-sectional view of the assembly of FIG. 2 after the next process step according to this example;
FIG. 6 is a cross-sectional view of the assembly of FIG. 2 after the next process step according to this example;
FIG. 7 is a cross-sectional view of a solar cell assembly or airfoil structure as fabricated in FIG. 6 after removal from the fixture according to this example;
FIG. 8 is a perspective view of an airfoil of FIG. 7;
FIG. 9 is a perspective view of an exemplary embodiment of a watercraft having a solar assembly, according to the present disclosure, attached to a non-planar surface of the watercraft;
FIG. 10 is a perspective view of an exemplary embodiment of an aircraft having a solar assembly, according to the present disclosure, attached to different, non-planar surfaces of the aircraft; and
FIGS. 11 and 12 are perspective views of exemplary embodiments of land vehicles having solar assemblies, according to the present disclosure, attached to surfaces of the land vehicles.

### DESCRIPTION OF ILLUSTRATIVE EMBODIMENTS

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

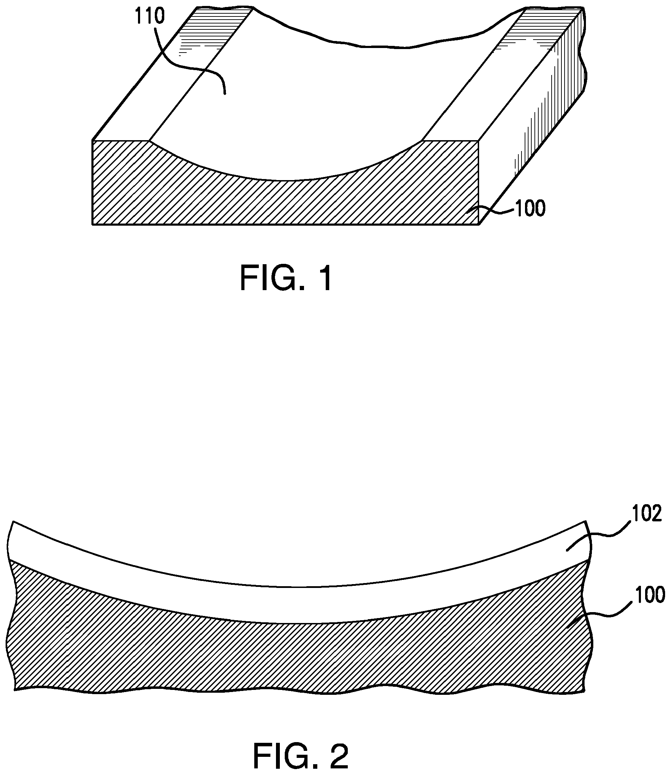

FIG. 1 - FIG. 7 describe an example of an assembly process according to the present disclosure.

FIG. 1 is a perspective view of a fixture 100 for assembling the airfoil according to an example of the present disclosure. The operative surface 110 of the fixture is generally concave and in the "negative" shape of the convex solar cell assembly to be formed, which in one embodiment is a portion of an airfoil.

FIG. 2 is an enlarged cross-sectional view of the surface of the fixture of FIG. 1 after placement of an ethylene tetrafluoroethylene (EFTE) film 102 on the surface 110 of the fixture.

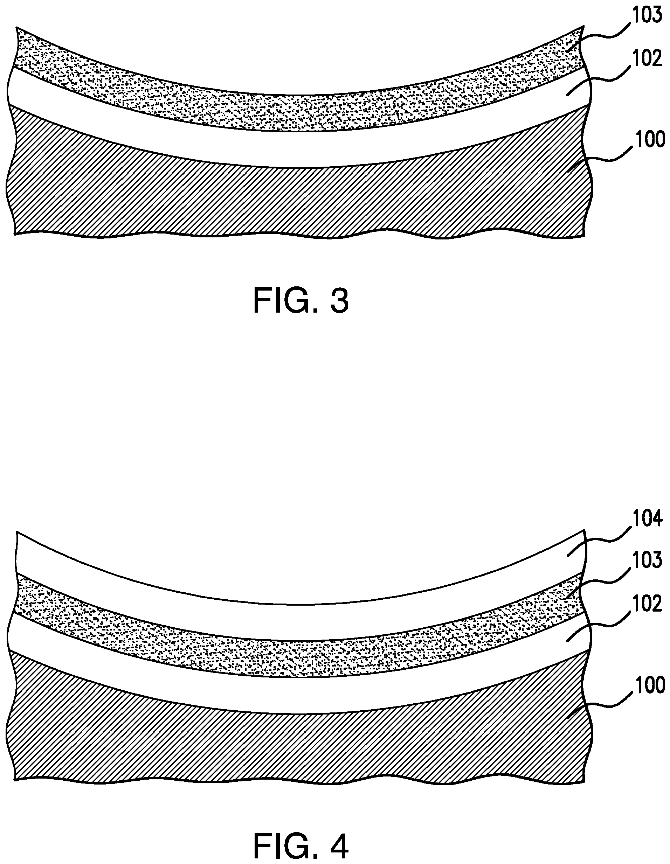

FIG. 3 is a cross-sectional view of the assembly of FIG. 2 after the next process step of mounting a film 103 composed of a pressure sensitive adhesive directly over the ETFE film 102. In an example, the pressure sensitive adhesive may be a non cross-linked silicone adhesive.

In some embodiments, the pressure sensitive adhesive film is between 0.001 and 0.010 inches (0.0254 mm - 0.254 mm) in thickness.

In some embodiments, the array of solar cells is between 0.010 and 0.030 inches (0.254 mm - 0.762 mm) in thickness.

FIG. 4 is a cross-sectional view of the assembly of FIG. 3 after the next process step of mounting an array of interconnected solar cells 104 directly over the adhesive film 103. In this example, the solar cells are placed "facing down", i.e. the surface of the solar cell that in use is to be irradiated by the sun is facing downwards. In this example, the top layer of the resulting assembly will be formed by the ETFE layer as will be explained herein.

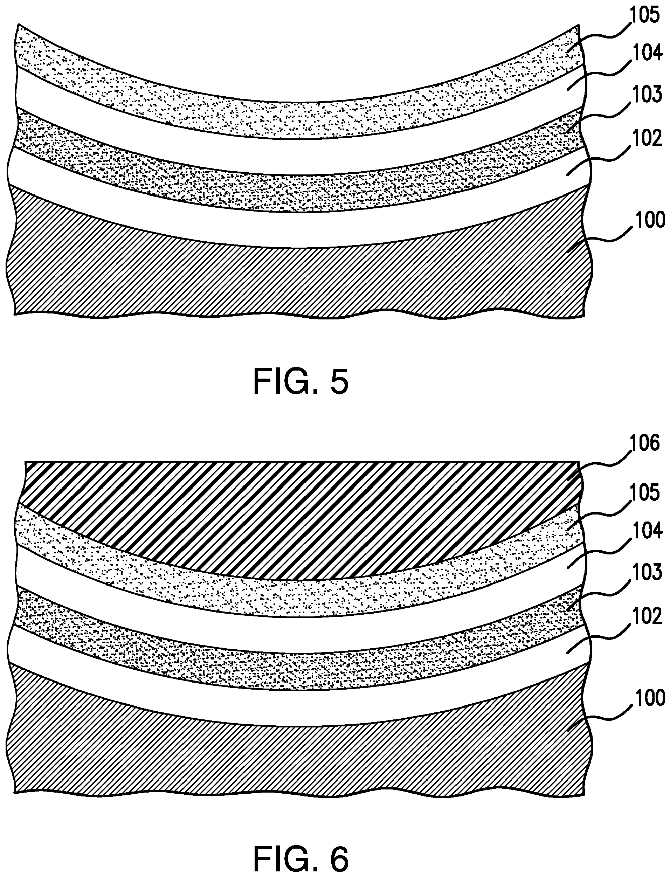

FIG. 5 is a cross-sectional view of the assembly of FIG. 4 after the next process step of mounting an uncured supporting film 105 composed of a composite material directly on the pressure sensitive adhesive film 103, and co-curing the film 105 of composite material so that the array of interconnected solar cells is bonded to the supporting film. The supporting film is thus placed on the backside of the solar cells, i.e. the side of the solar cells that in use is not configured to be irradiated by the sun.

FIG. 6 is a cross-sectional view of the assembly of FIG. 5 after the next process step in which a support structure 106 is bonded to the supporting film 105. In one embodiment, the supporting structure is an airfoil.

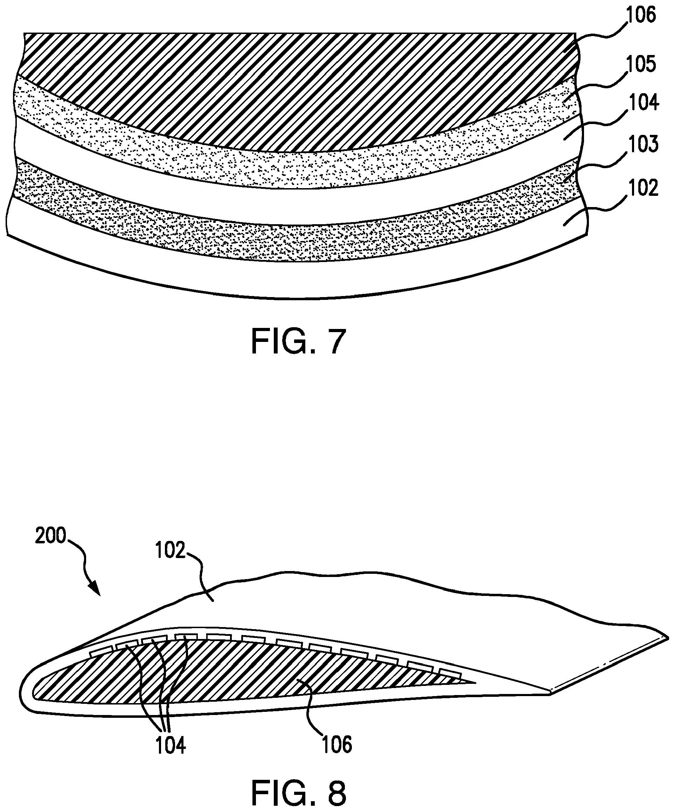

FIG. 7 is a cross-sectional view of a solar cell assembly or airfoil structure 106 as fabricated in FIG. 6 after removal from the fixture 100. The combination of the adhesive and the co-curing of the supportive film provide for an effective and relatively simple assembly procedure. The ETFE film provides for easy release from the fixture and a resulting smooth outer surface. The resulting airfoil may have a good aerodynamic performance in spite of the solar cells thanks to the smooth outer surface.

FIG. 8 is a perspective view of an airfoil 200 with individual solar cells 104 mounted on the top surface thereof, with the top surface being formed by the EFTE film 102.

In addition to an airfoil, the present technique may be used to fabricate solar cells on a wide variety of surfaces, apparatus and objects, in particular the non-planar surface of a variety of different vehicles or other structures (e.g., building materials).

Exemplary aircraft having non-planar surfaces include aerostats (which are lighter than air), and aerodynes (which are heavier than air). Exemplary aerostats can include, for example, unpowered vessels (e.g., balloons such as hot air balloons, helium balloons, and hydrogen balloons) and powered vessels (e.g., airships or dirigibles). Exemplary aerodynes can include, for example, unpowered vessels (e.g., kites and gliders) and powered vessels (e.g., airplanes and helicopters). Exemplary aerodynes can be fixed wing vessels (e.g., airplanes and gliders) or rotorcraft (e.g., helicopters and autogyros).

Exemplary watercraft having non-planar surfaces can be motorized or non-motorized, and can be propelled or tethered. Exemplary watercraft can include surface vessels (e.g., ships, boats, and hovercraft) and submersible vessels (e.g., submarines and underwater flotation vessels).

Exemplary land vehicles having non-planar surfaces can be motorized (e.g., automobiles, trucks, buses, motorcycles, rovers, and trains) or non-motorized (e.g., bicycles). In all such applications, aerodynamic performance may be important and may be improved by the assembly procedures disclosed herein resulting in a smooth outer surface.

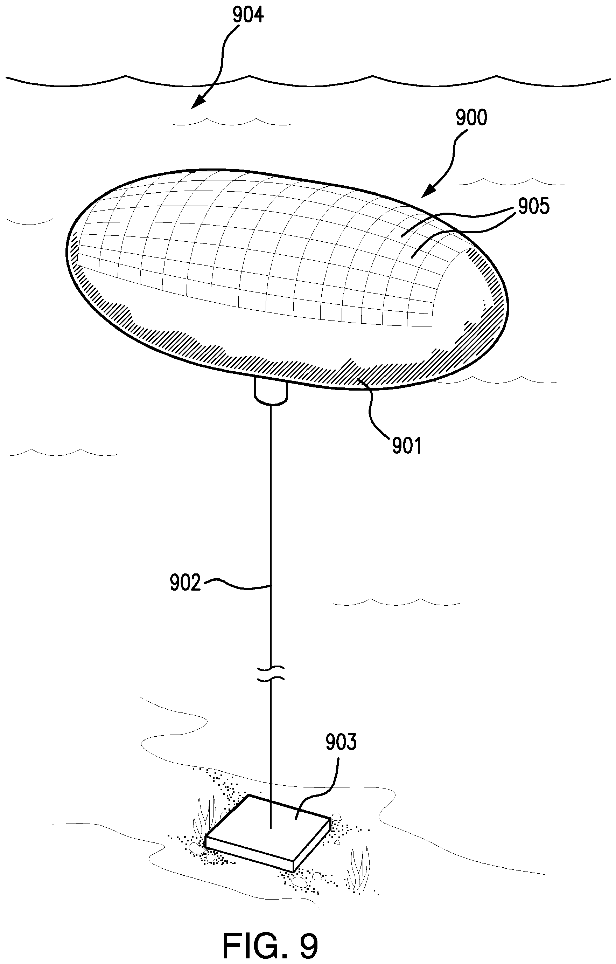

FIG. 9 is a perspective view of an exemplary embodiment of a watercraft. A submersible watercraft 904 has a non-planar surface and is attached to platform 903 via tether 902. Submersible watercraft 904 includes the underwater flotation vessel 901 that is held at a desired depth below the water surface by controlling the length of the tether 902. The solar cell assembly 900 is attached to a non-planar surface of the underwater flotation vessel 901. In certain embodiments, when light impinges on the solar cell assembly 900 of submersible watercraft 904, electrical current generated from the solar cell assembly 900 can be provided to platform 903 via the tether 902.

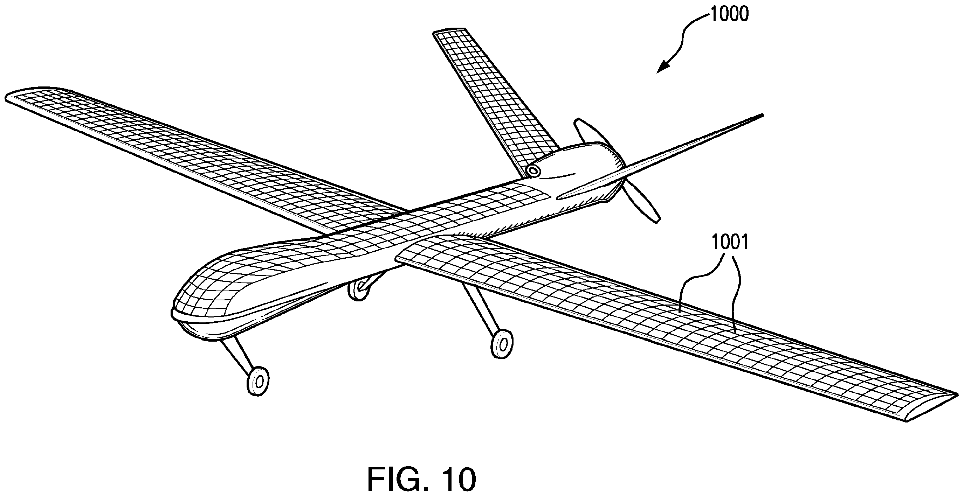

FIG. 10 is a perspective view of an exemplary embodiment of an unmanned aircraft. Aircraft 1000 has a plurality of non-planar surfaces and is a fixed wing vessel. The solar cell assembly 1001 may be attached to a non-planar surface of the wing of the aircraft 1000 and/or to a fuselage surface and/or tail wing surface. In certain embodiments, when light impinges on the solar cell assembly 1001 of aircraft 1000, electrical current generated from the solar cell assembly 1001 can be provided for operation of systems (e.g., navigational systems, propulsion systems, and the like) of aircraft 1000.

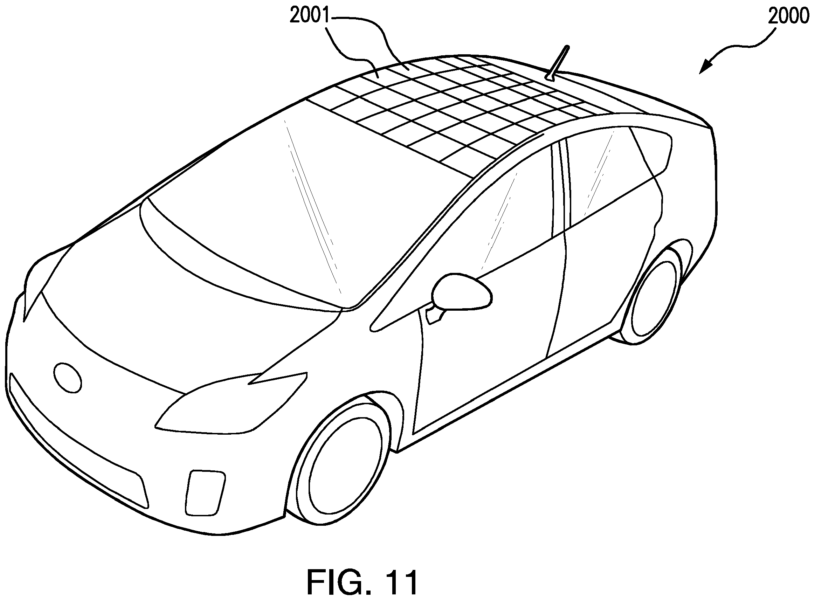

FIG. 11 is a perspective view of an exemplary embodiment of a land vehicle. Land vehicle 2000 has a non-planar roof surface and is an automobile. The solar cell assembly 2001 is attached to a non-planar surface of an automobile 2000. In certain embodiments, when light impinges on the solar cell assembly 2001 of automobile 2000, electrical current generated from solar cell assembly 2001 can be provided for operation systems (e.g., navigational systems, propulsion systems, and the like) of automobile 2000. In certain embodiments, automobile 2000 is a hybrid or electric powered automobile.

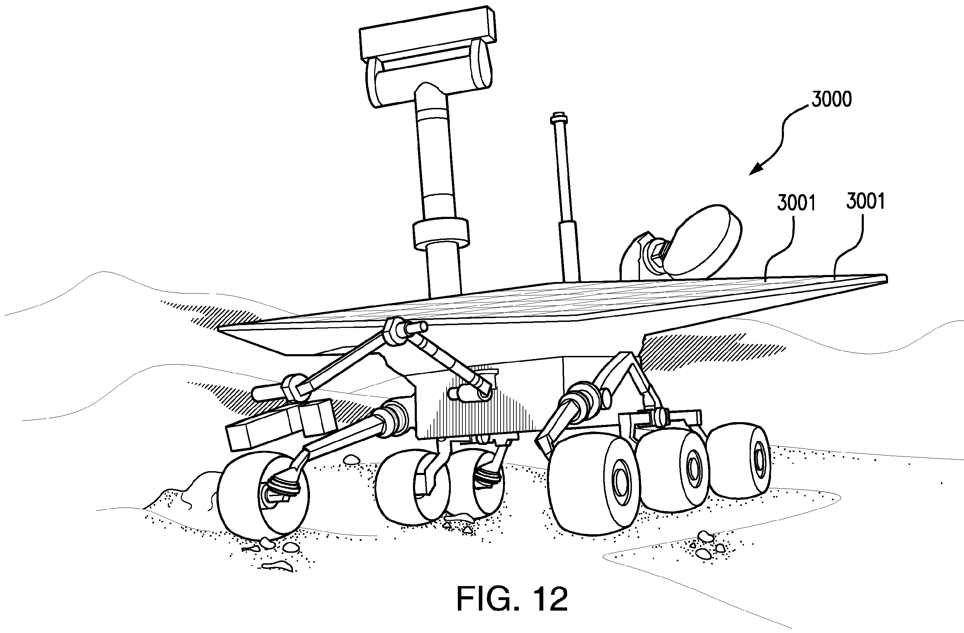

FIG. 12 is a perspective view of another exemplary embodiment of a land vehicle. Land vehicle 3000 may have a planar or a non-planar surface and is a rover that can be used for land navigation and/or exploration on earth or other planets. The solar cell assembly 3001 is attached to a surface of the rover 3000. In certain embodiments, when light impinges on the solar cell assembly 3001 of rover 3000, electrical current generated from solar cell assembly 3001 can be provided for operation of systems (e.g., navigational systems, propulsion systems, and the like) of rover 3000. In certain embodiments, rover 3000 is a hybrid or electric powered land vehicle.

Although some specific embodiments of the present disclosure have been demonstrated in detail with examples, it should be understood by a person skilled in the art that the above examples are only intended to be illustrative but not to limit the scope of the present disclosure. It should be understood that the above embodiments can be modified without departing from the scope of the present disclosure which are to be defined by the attached claims and all changes that come within the meaning thereof are intended to be embraced therein.

## Claims

1. A method of fabricating a solar cell array comprising:
providing an assembly fixture having a smooth, concave surface;
mounting a supporting film layer composed of ehylene tetrafluorethylene (ETFE) directly on the surface of the fixture;
mounting a pressure sensitive adhesive directly over the supporting film layer;
mounting an array of interconnected solar cells having a front light receiving side and a back side, with the front side being mounted directly over the adhesive;
mounting an uncured supporting film composed of a composite material directly on the back side of the solar cells;
co-curing of the film of composite material to bond the film of composite material directly to the back side of the solar cells; and
removing the ETFE film layer with the array of interconnected solar cells and the bonded and cured film of composite material from the assembly fixture.

2. A method as defined in claim 1, wherein the supporting film of composite material is between 0.001 and 0.020 inches (0.0254 mm - 0.508 mm) in thickness.

3. A method as defined in claim 1 or 2, wherein the supporting film of composite material is composed of a para-aramid fabric.

4. A method as defined in claim 1 or 2, wherein the supporting film of composite material is a pre-assembly of polyimide film, a pressure sensitive adhesive and a release liner.

5. A method as defined in claim 4, wherein the pre-assembly is bonded to a composite substrate, and optionally wherein bonding comprises co-curing the polyimide film.

6. A method according to claim 4 or 5, wherein the composite substrate includes a composite face sheet.

7. A method as defined in claim 6, and the pre-assembly is bonded to the composite face sheet by co-curing the polyimide film to the composite face sheet.

8. A method as defined in any of claims 1 - 7, wherein the assembly fixture has a concave surface with a surface roughness of less than 0.001 inches (25.4 microns) rms.

9. A method as defined in any of claims 1 - 8, wherein the concave surface of the assembly fixture has a negative shape of an airfoil.

10. A method as defined in any of claims 1 - 9, further comprising bonding a foam supporting structure to the supporting member.

11. A method as defined in any of claims 1 - 10, wherein the pressure sensitive adhesive is a single monomer or co-monomer silicone blend, and optionally wherein the pressure sensitive adhesive is a film of between 0.001 and 0.010 inches (0.0254 mm - 0.254 mm) in thickness.

12. A method as defined in any of claims 1 - 11, wherein the array of solar cells is between 0.010 and 0.030 inches (0.254 mm - 0.762 mm) in thickness.

13. A method as defined in any of claims 1 - 12, wherein the array of interconnected solar cells are III-V compound semiconductor multijunction solar cells.

## Patentansprüche

1. Ein Verfahren zur Herstellung einer Solarzellenanordnung, das Folgendes umfasst:
Bereitstellung einer Montagevorrichtung mit einer glatten, konkaven Oberfläche;
Anbringen einer Trägerschicht aus Ehtylentetrafluorethylen (ETFE) direkt auf der Oberfläche der Vorrichtung;
Anbringen eines druckempfindlichen Klebstoffs direkt auf der Trägerschicht;
Montieren einer Anordnung von miteinander verbundenen Solarzellen mit einer vorderen Lichtempfangsseite und einer Rückseite, wobei die Vorderseite direkt über dem Klebstoff angebracht wird;
Anbringen einer ungehärteten Trägerfolie aus einem Verbundmaterial direkt auf der Rückseite der Solarzellen;
Co-Härten der Folie aus Verbundmaterial, um die Folie aus Verbundmaterial direkt mit der Rückseite der Solarzellen zu verbinden; und
Entfernen der ETFE-Folienschicht mit der Anordnung von miteinander verbundenen Solarzellen und der gebundenen und ausgehärteten Folie aus Verbundmaterial aus der Montagevorrichtung.

2. Verfahren nach Anspruch 1, wobei der Trägerfilm aus Verbundmaterial eine Dicke zwischen 0,001 und 0,020 Zoll (0,0254 mm - 0,508 mm) aufweist.

3. Verfahren nach Anspruch 1 oder 2, wobei die Trägerfolie aus Verbundmaterial aus einem Para-Aramid-Gewebe besteht.

4. Verfahren nach Anspruch 1 oder 2, wobei das Trägerfolienverbundmaterial eine Vorbaugruppe aus Polyimidfolie, einem Haftkleber und einer Trennfolie ist.

5. Verfahren nach Anspruch 4, bei dem die Vormontage an ein Verbundsubstrat geklebt wird, und bei dem das Kleben gegebenenfalls das Aushärten der Polyimidfolie umfasst.

6. Verfahren nach Anspruch 4 oder 5, wobei das Verbundsubstrat eine Verbunddeckschicht enthält.

7. Verfahren nach Anspruch 6, wobei die Vorbaugruppe durch gemeinsames Aushärten der Polyimidfolie mit der Verbundstoff-Deckschicht an die Verbundstoff-Deckschicht gebunden wird.

8. Verfahren nach einem der Ansprüche 1 bis 7, wobei die Montagevorrichtung eine konkave Oberfläche mit einer Oberflächenrauhigkeit von weniger als 0,001 Zoll (25,4 Mikron) rms aufweist.

9. Verfahren nach einem der Ansprüche 1 bis 8, wobei die konkave Oberfläche der Montagevorrichtung eine negative Form eines Tragflügels aufweist.

10. Verfahren nach einem der Ansprüche 1 bis 9, das ferner das Verbinden einer Schaumstoffstützstruktur mit dem Stützelement umfasst.

11. Verfahren nach einem der Ansprüche 1 bis 10, wobei der druckempfindliche Klebstoff ein Einzelmonomer oder eine Co-Monomer-Silikonmischung ist und wobei der druckempfindliche Klebstoff optional ein Film mit einer Dicke zwischen 0,001 und 0,010 Zoll (0,0254 mm - 0,254 mm) ist.

12. Verfahren nach einem der Ansprüche 1 bis 11, wobei die Anordnung von Solarzellen eine Dicke zwischen 0,010 und 0,030 Zoll (0,254 mm - 0,762 mm) hat.

13. Verfahren nach einem der Ansprüche 1 bis 12, wobei die Anordnung von miteinander verbundenen Solarzellen III-V-Verbindungshalbleiter-Solarzellen mit Mehrfachübergang sind.

## Revendications

1. Méthode de fabrication d'un réseau de cellules solaires comprenant :
fournir un dispositif d'assemblage ayant une surface lisse et concave ;
monter une couche de film de support composée d'éthylène tétrafluoréthylène (ETFE) directement sur la surface du dispositif ;
monter un adhésif sensible à la pression directement sur la couche de film de support ;
monter un réseau de cellules solaires interconnectées ayant une face avant de réception de la lumière et une face arrière, la face avant étant montée directement sur l'adhésif ;
monter un film de support non durci composé d'un matériau composite directement sur la face arrière des cellules solaires ;
co-cuire du film de matériau composite pour coller le film de matériau composite directement à la face arrière des cellules solaires ; et
retirer la couche de film ETFE avec le réseau de cellules solaires interconnectées et le film de matériau composite collé et durci du dispositif d'assemblage.

2. Méthode définie dans la revendication 1, dans laquelle le film de support du matériau composite a une épaisseur comprise entre 0,001 et 0,020 pouces (0,0254 mm - 0,508 mm).

3. Méthode définie dans la revendication 1 ou 2, dans laquelle le film de support du matériau composite est composé d'un tissu para-aramide.

4. Méthode définie dans la revendication 1 ou 2, dans laquelle le matériau composite du film de support est un pré-assemblage de film polyimide, d'un adhésif sensible à la pression et d'un revêtement antiadhésif.

5. Méthode définie dans la revendication 4, dans laquelle le pré-assemblage est collé à un substrat composite, et dans laquelle le collage comprend éventuellement la co-cuisson du film de polyimide.

6. Méthode selon la revendication 4 ou 5, dans laquelle le substrat composite comprend une feuille de surface composite.

7. Méthode définie dans la revendication 6, le pré-assemblage étant collé à la feuille de surface composite par co-cuisson du film polyimide sur la feuille de surface composite.

8. Méthode définie dans l'une des revendications 1 à 7, dans laquelle le dispositif d'assemblage présente une surface concave dont la rugosité est inférieure à 0,001 pouce (25,4 microns) rms.

9. Méthode définie dans l'une des revendications 1 à 8, dans laquelle la surface concave du dispositif d'assemblage a la forme négative d'un profil aérodynamique.

10. Méthode définie dans l'une des revendications 1 à 9, comprenant en outre le collage d'une structure de support en mousse sur l'élément de support.

11. Méthode définie dans l'une des revendications 1 à 10, dans laquelle l'adhésif sensible à la pression est un monomère unique ou un mélange de silicone co-monomère, et facultativement dans laquelle l'adhésif sensible à la pression est un film d'une épaisseur comprise entre 0,001 et 0,010 pouces (0,0254 mm - 0,254 mm).

12. Méthode définie dans l'une des revendications 1 à 11, dans laquelle le réseau de cellules solaires a une épaisseur comprise entre 0,010 et 0,030 pouces (0,254 mm - 0,762 mm).

13. Méthode définie dans l'une des revendications 1 à 12, dans laquelle le réseau de cellules solaires interconnectées est constitué de cellules solaires multi-jonctions à semi-conducteur composé III-V.
